# EUROPÄISCHE PATENTANMELDUNG

(11) **EP 0 915 515 A2**
(43) Veröffentlichungstag der Anmeldung: **12.05.1999**
(21) Anmeldenummer: 98118503.6
(22) Anmeldetag: 30.09.1998
(51) Int. Cl.: H01L 25/065, H01L 23/64

(54) **Anordnung zum Übertragen von elektrischen Signalen zwischen einem auf einer Trägerplatte thermisch isoliertem Modul und angrenzenden Nachbarmodulen**

(30) Priorität: 30.10.1997 DE 19748005
(71) Anmelder: SIEMENS AKTIENGESELLSCHAFT, 80333 München (DE)
(72) Erfinder: Weiske, Claus-Jörg, 82256 Fürstenfeldbruck (DE)

(57) **Zusammenfassung**

Anordnung zum Übertragen von elektrischen Signalen zwischen einem thermisch isoliertem Modul (M1) und angrenzenden Nachbarmodulen (M2, M3) wobei der Modul (M1) von der Unterseite der Trägerplatte (1) her gekühlt oder beheizt wird und Signalleitungen (L1, L2; L3, L4; L5, L6, L7) an den Modul (M1) geführt werden, zwischen denen sich im wesentlichen ein elektrisches Feld ausbildet, da die Unterseite der Trägerplatte (1) des Moduls nicht mit den Masseflächen der Nachbarmodulen (M2, M3) verbunden ist.

## Beschreibung

Die Erfindung betrifft eine Anordnung nach dem Oberbegriff des Anspruchs 1.

In elektrischen und elektro-optischen Bausteinen besteht häufig die Anforderung, Komponenten eines Moduls gegenüber benachbarten Nachbarmodulen sowie der Umgebung thermisch zu isolieren. Der Modul kann beispielsweise durch ein Peltier-Element gekühlt oder geheizt werden, um stets die für die Schaltung erforderliche optimale Arbeitstemperatur zu erreichen.

Sollen zwischen dem Modul und benachbarten Nachbarmodulen elektrische Signale mit hohen Datenraten bzw. hohen Freqenzen im Gbit/s bzw. GHz(Gigahertz)-Bereich geführt werden, so ist eine Signalführung auf den Trägerplatten mit dem Wellenwiderstand angepaßten Leitungsstrukturen üblich. Geeignete Leitungskonfigurationen sind in dem 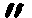 Transmission Line Handbook" von Brian C. Wadell, Artech House Inc., London 1991 beispielsweise auf den Seiten 79 und 199 beschrieben. Auf der Unterseite der Trägerplatte befindet sich im allgemeinen eine Metallisierung. Diese leitende Schicht wird als Massepotential verwendet.

Aus Gründen der mechanischen Stabilität sowie zur Wärmeableitung werden die Trägerplatten häufig auf Metallplatten montiert. Die Forderung nach einer guten thermischen Isolation kann dann beispielsweise dadurch erreicht werden, daß die Trägerplatte in mehrere Teile für den thermisch isolierten Modul vorgesehenen Bereich und die weiteren Nachbarmodule zerlegt wird. Die Nachbarmodule können elektrisch mit den äußeren Schaltungen verbunden sein.

Werden elektrische Signale über eine Mikrostreifenleitung übertragen, so entsteht ein elektrisches Feld zwischen der Leitung und der als Massepotential dienenden Metallisierung bzw. den Metallplatten. Wenn die Leiterbahn und die Massefläche zunächst zur Erhöhung des thermischen Widerstandes unterbrochen und dann wieder zur Aufrechterhaltung der elektrischen Verbindung beispielsweise durch Bonddrähte verbunden werden, so treten an diesen Verbindungsstellen Reflexionen auf. Bereits bei wenigen Gbit/s bzw. GHz bewirken diese Reflexionen nicht mehr zu tolerierende Dämpfungen. Diese wären zwar durch eine gute Masseverbindung zu beseitigen, doch durch diese wird auch wieder eine unerwünschte Wärmebrücke hergestellt.

Die Aufgabe der Erfindung besteht nun darin, bei einer guten thermischen Isolation des Moduls eine geeignete Anordnung zum Übertragen von hochfreguenten Signalen anzugeben.

Diese Aufgabe wird durch die in Anspruch 1 angegebenen Merkmale gelöst.

Vorteilhafte Weiterbildungen der Erfindung sind in den Unteransprüchen angegeben.

Der große Vorteil der Erfindung beruht darin, daß praktisch ohne zusätzlichen Aufwand reflexionsarme und daher verlustarme Signalverbindungen bei gleichzeitiger thermischer Isolation realisiert werden können.

Wird eine Trägerplatte mit einer hohen Wärmeisolation verwendet, so können auf ihr der thermisch isolierte Modul und die angrenzenden Nachbarmodule untergebracht werden. Lediglich die Metallisierung auf der Trägerplattenrückseite und die Metallplatten müssen durchgetrennt werden. Zur Erhöhung der thermischen Isolation kann auch die gemeinsame Trägerplatte in den Grenzbereichen des Moduls eingekerbt bzw. teilweise aufgetrennt sein.

Eine optimale Wärmeisolation - beispielsweise bei keramischen Trägerplatten - wird jedoch durch die Verwendung von getrennten Trägerplatten für den Modul und die angrenzenden Nachbarmodule erzielt. Die elektrischen Verbindungen werden dabei durch Bonddrähte hergestellt.

Die Erfindung bedingt die Verwendung von Leitungstypen, bei denen sich zwischen mindestens zwei eng gekoppelten Leitungen zumindest der wesentliche Teil des elektrischen Feldes ausbildet.

Für die Übertragung von Differenzsignalen ist besonders die differentielle Mikrostreifenleitung geeignet. Auf Masseverbindungen zum Modul kann unter Umständen ganz verzichtet werden, beispielsweise bei einem Modul, der einen optoelektrischen oder elektrooptischen Wandler darstellt.

Für den Fall, daß kein Differenzsignal übertragen werden soll, eignen sich beispielsweise koplanare Leitungstypen, die einen Mittelleiter und zwei hierzu parallel verlaufende Außenleiter benötigen. Die Außenleiter können hierbei zusätzlich zur Herstellung einer Masseverbindung verwendet werden.

Ist aus schaltungstechnischen Gründen eine Masseverbindung und/oder Stromversorgung erforderlich, so ist es vorteilhaft, wenn diese über auf der Leitungsseite der Trägerplatte verlaufenden Leitungen oder leitende Flächen hergestellt wird. Über diese kann auch die Metallisierung der Trägerplattenrückseite auf Massepotential gelegt werden.

Die Erfindung wird aufgrund von Ausführungsbeispielen näher erläutert.

Es zeigen:
- Figur 1: den Potentialverlauf bei einer Mikrostreifenleitung,
- Figur 2: ein Ausführungsbeispiel mit einer durchgehenden Trägerplatte,
- Figur 3: ein Ausführungsbeispiel mit separaten Trägerplatten,
- Figur 4: den Potentialverlauf bei einer differentiellen Mikrostreifenleitung,
- Figur 5: einen dazugehörigen Dämpfungsverlauf,
- Figur 6: ein Ausführungsbeispiel mit Koplanarleitern und
- Figur 7: den dazugehörigen Potentialverlauf.

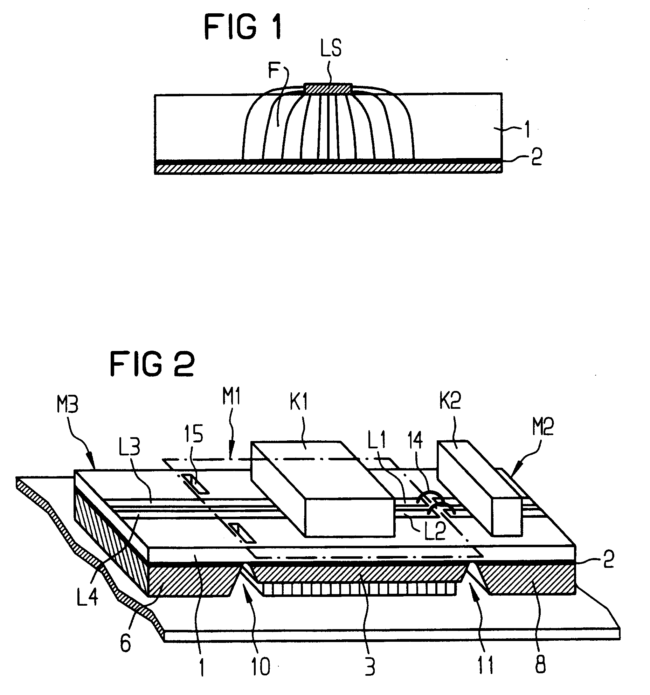

In Figur 1 ist das elektrische Feld F eines Mikrostreifenleiters LS, der auf einer Trägerplatte 1 verläuft, gegenüber einer auf der Unterseite der Trägerplatte angebrachten Massepotential führenden Metallisierung 2 dargestellt. Wird nun der Leiter und/oder die Metallisierung unterbrochen und dann über Bonddrahte wieder elektrisch leitend verbunden, so kommt es bei hohen Frequenzen zu Refexionen, die zu hohen Dämpfungswerten führen.

In Figur 2 ist ein Prinzipschaltbild der Erfindung dargestellt, mit der diese Refexionen vermieden werden. Ein Bauelement/eine Komponente K1 eines Moduls M1 (gestrichelte Linie) ist auf einer Trägerplatte 1 angeordnet. An den Modul grenzen zwei Nachbarmodule M2 und M3 an. Eine Komponente K2 (bzw. ein Bauelement) des Nachbarmoduls M2 ist über eine Signalleitung L1, L2 mit dem Komponente K1 des Moduls verbundene. In diesem Fall besteht eine weitere Verbindung über eine Signalleitung L3, L4 zwischen dem Modul und dem weiteren Nachbarmodul M3. Im Bereich der angrenzenden Nachbarmodule M2 und M3 ist die Unterseite der Trägerplatte 1 mit einer elektrisch und thermisch leitenden Auflage versehen, hier besteht sie aus einer Metallisierung 2 und damit verbundenen Metallplatten 8 bzw. 6, die zur Wärmeableitung dienen. Auch im Bereich des Moduls M1 weist die Unterseite der Trägerplatte eine aber von den anderen Metallplatten isolierte Auflage - eine Metallplatte 3 - auf, die über eine ebenfalls von der Umgebung isolierte Metallisierung mit der Trägerplatte 1 verbunden ist. Durch quer zu den Signalleitungen verlaufende Nuten 10 und 11 sind die Metallisierung und die Metallplatten des Moduls von den angrenzenden Nachbarmodulen getrennt, so daß eine vollständige elektrische und eine gute thermische Isolierung gegeben ist. Durchbrüche 15 können die thermische Isolierung weiter verbessern. Auch können die Leiter L3 und L4 zur Vergrößerung des Wärmewiderstandes unterbrochen und durch Bonddrähte 14 überbrückt sein.

Die Wärmeableitung der an den Modul angrenzenden Nachbarmodule erfolgt über die Metallplatten 6 und 8 sowie eine Bodenplatte 9. Die Metallplatte 3 des Moduls M1 ist mit einem Peltier-Element 4 verbunden, über das sowohl geheizt als auch gekühlt werden kann. Das Bauelement/die Komponente K1 des Moduls können deshalb bei einer gleichbleibenden Umgebungstemperatur arbeiten.

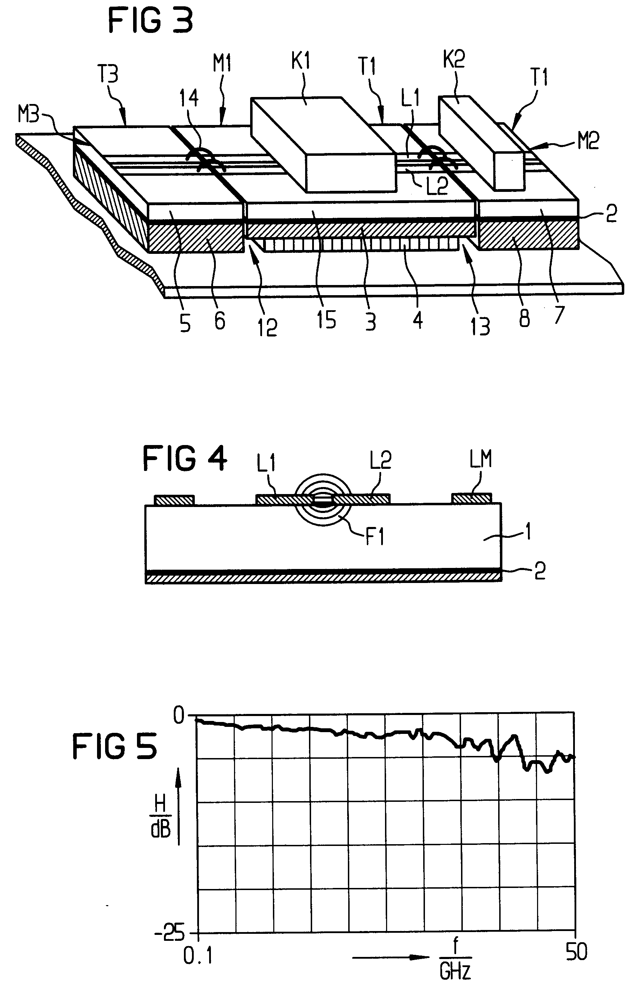

In Figur 3 ist eine Variante dargestellt, bei der die Trägerplatte und die Metallplatte des Moduls M1 von denen der angrenzenden Nachbarmodule M2 und M3 vollständig getrennt ist. Die Leiter L1 bis L4 sind mit Bonddrähten 14 miteinander verbunden. Bei dieser Variante wird eine maximale thermische Isolation erreicht. Der Modul M1 und seine Nachbarmodule M2, M3 werden in der Regel als funktionelle Einheit in einem gemeinsamen Gehäuse untergebracht sein.

Zur Übertragung von Differenzsignale eignet sich eine sogenannte differentielle Mikrostreifenleitung mit zwei eng benachbarten parallelen Leitern, zwischen denen im wesentlichen sich das in Figur 4 dargestellte elektrische Feld F1 ausbildet. Falls für aktive Bauelemente Massepotential benötigt wird, kann dies über einen weiteren Masseleiter LM an das Bauelement geführt werden. Auch können weitere Signalleitungen und Spannungszuführungen vorgesehen sein.

Ebenso kann eine Durchkontaktierung von dem Masseleiter LM oder entsprechenden Massefläche zur Metallisierung 2 erfolgen.

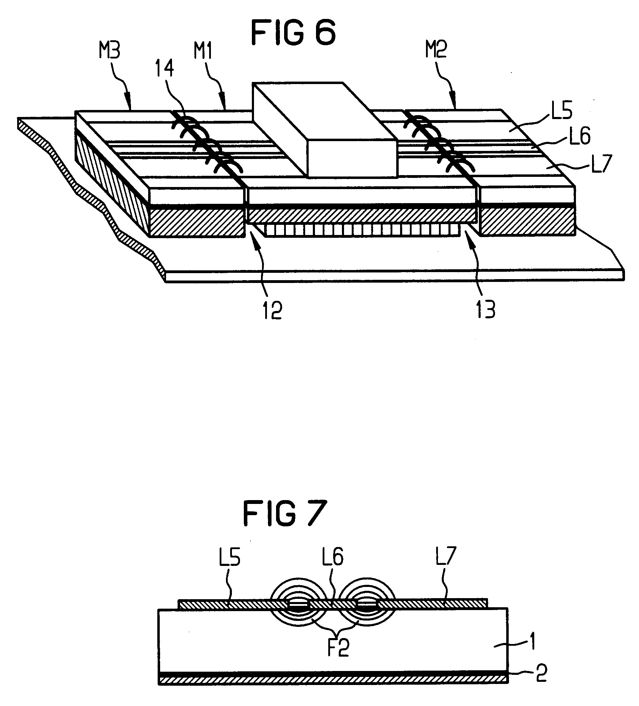

In Figur 5 ist der Pegel P des übertragenen Signals in Dezibel (dB) in Abhängigkeit von der zu übertragenden Frequenz f/GHz
dargestellt. Die Dämpfung nimmt mit zunehmender Frequenz nur schwach und ohne besondere Resonanzen zu.

Figur 6 zeigt die Verwendung einer sogenannten Koplanarleitung mit drei Leiterbahnen, einem Innenleiter L6 und zwei Außenleitern L5, L7. Diese Leitungen sind für unsymmetrische Signale geeignet. Die Außenleiter sind elektrisch miteinander verbunden. Deshalb bilden sich entsprechend Figur 7 symmetrische elektrische Felder F3 zwischen dem Innenleiter und den Außenleitern aus. Der Frequenzverlauf dieser Leitung entspricht etwa dem in Figur 5 gezeigten.

Die Außenleiter können hierbei ebenfalls das Massepotential führen und erforderlichenfalls mit der Metallisierung 2 und gegebenenfalls über diese mit den Metallplatten sein.

Für die erfindungsgemäße Anordnung sind alle Leitungstypen geeignet, bei denen sich das elektrische Feld im wesentlichen nicht gegenüber dem Massepotential ausbreitet.

## Patentansprüche

1. Anordnung zum Übertragen von elektrischen Signalen zwischen einem auf einer Trägerplatte (1) thermisch isolierten und von der Unterseite der Trägerplatte (1) her gekühlten oder beheizten Modul (M1) und mindesten einem angrenzenden Nachbarmodul (M2, M3), der auf der Unterseite seiner Trägerplatte (1, 5, 7) mit einer elektrisch leitenden Auflage (6, 8) versehen ist,
**dadurch gekennzeichnet,**
daß Signalleitungen (L1, L2; L3, L4; L5, L6, L7) an den Modul (M1) geführt werden, zwischen deren Leitern sich im wesentlichen ein elektrisches Feld ausbildet und
daß die Unterseite der Trägerplatte (1) im Bereich des Moduls (M1) von den angrenzenden elektrisch leitenden Auflagen (6, 8) elektrisch und thermisch isoliert ist.

2. Anordnung nach Anspruch 1,
**dadurch gekennzeichnet,**
daß eine elektrisch leitende Auflage (3) im Bereich des Moduls (M1) auf der Unterseite der Trägerplatte (1) vorgesehen ist, die von den entsprechenden Auflagen (6, 8) der benachbarten Nachbarmodule (M2, M3) getrennt ist und
daß die Signalleitungen (L1, L2; L3, L4) miteinander elektrisch verbunden sind.

3. Anordnung nach Anspruch 1,
**dadurch gekennzeichnet,**
daß der Modul (M1) und die mit ihm verbundenen Nachbarmodule (M2, M3) auf separaten Trägerplatten (15, 5, 7) angeordnet sind und daß nur die Signalleitungen (L1, L2; L3, L4) und nicht die Auflagen (6, 3, 8) der Unterseiten der Trägerplatte (1, 5, 7) elektrisch direkt miteinander verbunden sind.

4. Anordnung nach Anspruch 1 oder 2,
**dadurch gekennzeichnet,**
daß zum Verbinden der Signalleitungen (L1, L2, L3, L4) Bonddrähte (14) vorgesehen sind.

5. Anordnung nach einem der vorhergehenden Ansprüche,
**dadurch gekennzeichnet,**
daß zur Übertragung symmetrischer Signale Mikrostreifenleitungen (L1, L2; L3, L4) vorgesehen sind.

6. Anordnung nach Ansprüche 1 bis 5,
**dadurch gekennzeichnet,**
daß zur Übertragung von unsymmetrischen Signalen Koplanarleitungen (L5, L6, L7) mit einem Mittelleiter (L6) und zwei zu diesem parallel angeordneten Außenleitern (L5, L7) vorgesehen sind.

7. Anordnung nach einem der vorhergehenden Ansprüche,
**dadurch gekennzeichnet,**
daß Masseleitungen (LM) auf der Oberfläche der Trägerplatten (1,...) in einem möglichst großem Abstand zu den Signalleitungen (L1, L2; L3, L4; L5, L6, L7) geführt sind, so daß die Leitungseigenschaften nicht wesentlich beeinflußt werden.

8. Anordnung nach einem der vorhergehenden Ansprüche,
**dadurch gekennzeichnet,**
daß als leitende Auflage Metallplatten (3, 6, 8) und/oder eine Metallisierung vorgesehen ist.

9. Anordnung nach Anspruch 8,
**dadurch gekennzeichnet,**
daß die Masseleitung (LM) des Moduls mit der auf der Rückseite der Trägerplatte befindlichen leitenden Auflage (2, 3) elektrisch leitend verbunden ist.

10. Anordnung nach einem der vorhergehenden Ansprüche,
**dadurch gekennzeichnet,**
daß die Unterseite der Trägerplatte (1) des Moduls (M1) mit einem Kühl- und/oder Heizelement (4) verbunden ist.

11. Anordnung nach Anspruch 10,
**dadurch gekennzeichnet,**
daß als Kühl- und Heizelement (4) ein Peltier-Element vorgesehen ist.
